# FASCICULE DE BREVET EUROPEEN

(11) **EP 3 834 230 B1**
(45) Date de publication et mention de la délivrance du brevet: **13.07.2022**
(21) Numéro de dépôt: 19759669.5
(22) Date de dépôt: 06.08.2019
(51) Int. Cl.: H01L 25/07, H01L 25/16, H01L 25/18, H01L 21/98

(54) **CIRCUIT ÉLECTRIQUE DE PUISSANCE POUR CONVERTISSEUR DE PUISSANCE ÉLECTRIQUE**
ELEKTRISCHE LEISTUNGSSCHALTUNG FÜR EINEN ELEKTRISCHEN LEISTUNGSWANDLER
ELECTRICAL POWER CIRCUIT FOR AN ELECTRICAL POWER CONVERTER

(30) Priorité: 07.08.2018 FR 1857356
(43) Date de publication de la demande: 16.06.2021
(73) Titulaire: Safran Electrical & Power, 31702 Blagnac (FR); Elvia Printed Circuit Boards, 50200 Coutances (FR)
(72) Inventeur: PORET, Philippe, 31702 BLAGNAC (FR); BELNOUE, Olivier, 45390 ONDREVILLE SUR ESSONNE (FR)
(74) Mandataire: Cabinet Beau de Loménie
(86) Numéro de dépôt international: PCT/FR2019/051909
(87) Numéro de publication internationale: WO 2020/030876

(56) Documents cités:
- WO-A1-2017/144599

## Description

### Arrière-plan de l'invention

L'invention se rapporte à un circuit électrique de puissance pour un convertisseur de puissance, et plus particulièrement à la fabrication d'un substrat pour un circuit électrique de puissance d'un convertisseur de puissance d'un boîtier de commande de machines tournantes, par exemple pour des actionneurs de contrôle, des convertisseurs AC/DC ou DC/DC, des ventilateurs ou des machines de propulsion.

Dans les systèmes de conversion de puissance généralement utilisés pour la commande de machines tournantes ou de convertisseur, l'électronique de puissance utilisée pour la commande de la machine se présente sous la forme d'un boîtier situé soit dans une baie regroupant plusieurs de ces boîtiers soit, de manière autonome, dans l'environnement de la machine commandée.

L'utilisation et l'optimisation des composants de puissance requiert un transfert thermique optimal et une réduction de l'inductance parasite. L'intégration au plus près des enroulements de la machine, de l'électronique de puissance permet une optimisation en termes de volume, de refroidissement et de performance de l'ensemble de la chaine électrique.

De manière générale, ce boitier de commande regroupe, un système de filtrage de la tension d'alimentation, un convertisseur de puissance constitué principalement d'interrupteurs de puissance commandés suivant des lois de commande prédéfinies, un système de refroidissement et, dans le cas où le convertisseur est éloigné de la machine qu'il contrôle, un système de filtrage de sortie.

Le système de filtrage de la tension d'alimentation permet de réduire les perturbations émises par l'électronique de commande et circulant sur les lignes d'alimentation. L'éventuel système de filtrage de sortie permet de réduire les perturbations créées par le convertisseur lors de la commutation des interrupteurs de puissance. Et, le système de refroidissement permet d'évacuer les calories dissipées par l'électronique soit dans l'air, soit au travers d'un échange avec un fluide caloporteur. Le système de refroidissement permet en outre de ne pas dépasser les températures maximales admissibles au niveau de la jonction des semiconducteurs utilisés dans le convertisseur de puissance.

Les interrupteurs de puissance du convertisseur de puissance se présentent généralement, dans une première configuration destinée notamment pour des convertisseurs de quelques kilowatts, sous la forme de composants discrets montés sur un support du type circuit imprimé ou bien, dans une seconde configuration destinée notamment pour des puissance plus élevées, sous la forme de modules de puissance constitués principalement de puces nues brasées sur un support permettant d'interconnecter plusieurs puces entre elles, le tout étant protégé dans un boitier constituant le module proprement dit.

Dans la seconde configuration, un module de puissance standard se présente sous la forme d'un bloc de format rectangulaire qui intègre les différentes liaisons électriques aussi bien pour la partie puissance que pour les signaux bas niveaux utilisés pour contrôler les composants de puissance intégrés à l'intérieur du module.

Dans cette seconde configuration, un module de puissance est constitué, de manière générale, d'une embase sur laquelle est reporté un substrat au moyen d'une colle, ou bien au moyen d'un alliage apporté au cours d'une opération de brasure, ou encore au moyen du frittage de nanoparticules d'argent. Le substrat est généralement constitué de céramique sur laquelle sont déposés des conducteurs en aluminium ou bien en cuivre par liaison directe cuivre, ou « Direct Bonding Copper » (DBC) en anglais pour des conducteurs en cuivre, ou par liaison directe aluminium pour « Direct Bonding Aluminum » (DBA) pour des conducteurs en aluminium.

Le substrat sert de support au composants de puissance qui se présentent alors sous la forme de puces nues qui sont elles-mêmes soit collées au moyen d'une colle, soit brasées au moyen d'un apport d'alliage, soit frittées au moyen de l'apport de nanoparticules d'argent. Les composants de puissance sont connectés entre eux et vers les connexions externes du module au moyen de fils de liaison, généralement constitué d'aluminium, de cuivre ou d'or, aussi bien pour les connexion de puissance que pour les signaux de commande des composants de puissance

Dans certaines variantes de la seconde configuration, le module de puissance ne possède pas d'embase afin de permettre une conduction thermique plus efficace en évitant l'interface thermique inhérente à la liaison entre le substrat et l'embase du module.

Les interrupteurs de puissance réalisés selon la seconde configuration, c'est-à-dire utilisant des modules intégrés, nécessitent pour chaque nouvelle application le développement d'un substrat, voire d'une embase, spécifique par le fabricant de substrat induisant un niveau de cout de développement plus important ne permettant pas d'atteindre un cout récurrent faible dans le cas où les quantités de modules à produire restent faibles comme dans le cas d'une application aéronautique.

L'empilage des différentes couches nécessaires pour la réalisation du module qui est constitué d'une embase, d'un substrat, et de puces ainsi que les matériaux nécessaires à l'assemblage de ces différentes couches induisent une résistance thermique non négligeable du fait des différentes interfaces thermiques propres à l'assemblage et aux matériaux isolants participants à cet assemblage.

L'interface thermique nécessaire pour permettre une bonne liaison thermique entre le module et le système de management thermique peut également apporter soit des contraintes lors des phases d'assemblage en production, soit des limitations de durée de vie de l'assemblage, par exemple en présence de forte humidité, pouvant entraîner des dérives des propriétés électriques de l'interface dans le cas où celle-ci contribue à l'isolation entre les composants de puissance et le système de management thermique.

Dans la première configuration utilisée pour réaliser un cœur de puissance, des composants discrets sont brasés sur un circuit imprimé.

Dans le cas où les composants sont du type traversant, ils doivent être fixés mécaniquement au système de management thermique au travers d'une interface thermique qui doit également assurer l'isolation électrique entre le composant et le système de management thermique dans le cas où le potentiel électrique de ce dernier est différent de celui du composant de puissance.

Dans le cas où les composants de puissance utilisés sont du type "montés en surface", il est possible d'améliorer le transfert thermique à la verticale du composant en utilisant des pièces de cuivre ou d'autre matériau présentant une résistance thermique faible tout en assurant une faible dilatation relative des matériaux en regard. Lesdites pièces sont insérées dans la structure du circuit imprimé et réduisent ainsi la distance entre la face arrière du composant de puissance et la surface du système de management thermique.

Dans les deux cas décrits ci-dessus pour la première configuration, c'est-à-dire le cas de composants traversant et le cas de composants montés en surface, l'utilisation d'un circuit imprimé implique une limitation des courants transitant par les pistes de cuivre du circuit imprimé du fait de la section de cuivre utilisée pour le passage du courant, cette section dépendant elle-même de l'épaisseur maximale de cuivre utilisable pour réaliser l'assemblage des couches de circuit imprimé.

Les interrupteurs de puissance réalisés selon la première configuration sont beaucoup plus polyvalents que ceux du type selon la seconde et ne nécessitent pas un effort important en termes de cout de développement.

Le principal inconvénient des interrupteurs selon la première configuration est la limitation en courant liée à l'épaisseur maximale du cuivre utilisé pour la réalisation du circuit imprimé. L'épaisseur maximale généralement utilisée dans des circuits imprimés est d'environ 400 µm, alors que l'épaisseur de cuivre standard dans un circuit imprimé est de 35 µm.

De plus, l'interface thermique requise pour l'implantation du composant de puissance sur son système de management thermique génère, de manière similaire à la seconde configuration, des contraintes tant sur le plan industriel que sur le plan de la fiabilité et de la durabilité de l'assemblage.

WO 2017/144599 A1 (ABB SCHWEIZ AG [CH]; AUDI AG [DE]) 31 août 2017 (2017-08-31) divulgue un circuit électrique de puissance pour convertisseur de puissance électrique.

### Objet et résumé de l'invention

L'invention vise à fournir un circuit électrique de puissance d'un convertisseur de puissance électrique pour un boîtier de commande d'au moins une machine tournante dont les caractéristiques de transfert thermique entre les composants de puissance et le système de dissipation thermique et les caractéristiques électriques liées aux inductances parasites sont optimisées dans un encombrement réduit, le circuit électrique pouvant être utilisé pour toute puissance électrique à convertir.

Dans un premier objet de l'invention, il est proposé un circuit électrique de puissance comprenant un substrat présentant une première face sur lequel sont montés des composants électroniques de puissance et une seconde face opposée à la première face et destinée à coopérer avec un système de refroidissement.

Selon une caractéristique générale du premier objet de l'invention, le substrat comprend un empilement d'une pluralité de couches conductrices en matériau électriquement et thermiquement conducteur et d'au moins une couche isolante en matériau électriquement isolant, deux couches conductrices successives dans l'empilement étant séparées par une couche isolante, et lesdites couches conductrices et isolante(s) s'étendant dans des plans parallèles au plan dans lequel s'étend la première face du substrat et étant mécaniquement associées ensemble. Chaque couche conductrice présente deux faces opposées parallèles au plan dans lequel s'étend la première face du substrat et comporte, sur au moins une de ses deux faces, au moins un bossage s'étendant dans une direction perpendiculaire au plan dans lequel s'étend la première face du substrat, ledit au moins un bossage traversant au moins une autre couche conductrice et débouchant sur la première ou la seconde face du substrat.

Le premier objet de l'invention fournit ainsi un circuit de puissance doté d'un substrat pour des composants de puissance formé par la superposition de deux à N couches, ou plaques, d'un matériau électriquement et thermiquement conducteur tel que du cuivre ou un de ses alliages ou de l'aluminium ou un de ses alliages. Les couches sont associées entre elles et peuvent avoir une épaisseur de quelques dixièmes de millimètre à quelques millimètres en fonction de l'intensité électrique destinée à parcourir ladite couche conductrice. Chaque couche conductrice est en relief, c'est-à-dire qu'elle présente des bossages qui serviront soit à implanter des composants de puissance, soit à créer des puits thermiques sous la couche conductrice en fonction de leur emplacement dans l'empilage. Certaines couches présentent des trous permettant le passage des bossages des autres plaques. Les couches conductrices sont imbriquées et stratifiées entre elles en utilisant des feuilles de matériau isolant pouvant présenter elles-mêmes des reliefs permettant, par emboîtement entre les bossages, l'isolement des couches conductrices entre elles.

Des composants électroniques de puissance, tels que des puces nues ou des composants discrets, peuvent être assemblés sur la face supérieure de l'assemblage formant le substrat au moyen d'une colle, ou au moyen d'un alliage apporté au cours d'une opération de brasure, ou bien au moyen du frittage de nanoparticules d'argent.

Dans le cas par exemple d'un bras d'onduleur, l'utilisation d'un circuit de puissance doté d'un empilement de plaques conductrices assemblées mécaniquement ensemble permet de réduire la résistance thermique du convertisseur et d'obtenir un substrat présentant une résistance thermique faible et similaire pour tous les composants de puissance utilisés.

Un convertisseur électrique de puissance avec un tel substrat peut en outre être utilisé pour toutes les puissances électriques, l'intensité des courants pouvant traverser le substrat dépendant de l'épaisseur des plaques conductrices utilisées pour l'assemblage.

En outre, selon l'épaisseur des plaques conductrices, il est possible d'inclure des liaisons de puissance directement dans les plaques de cuivre permettant par exemple un assemblage direct du type vis-écrou de câbles, de barres d'alimentation ou encore de liaisons vers les charges alimentées.

Un tel convertisseur permet également de réduire l'inductance parasité liée à la boucle d'alimentation créée entre les polarités de l'alimentation et les composants de puissance. Cette réduction d'inductance parasite est obtenue grâce à l'utilisation de plans parallèles pour la liaison électrique vers les deux polarités d'alimentation du bras d'onduleur.

Le circuit électrique de puissance selon le premier objet de l'invention permet en outre une intégration, au plus près de composants de puissance, des composants nécessaire à leur commande en intégrant par exemple sur la face supérieure de l'assemblage, c'est-à-dire la première face du substrat, des zones permettant d'inclure directement des composants bas niveaux.

De préférence, les couches conductrices sont des plaques de matériau conducteur tel que des plaques de cuivre.

Selon les configurations, une couche conductrice peut comprendre des premiers bossages s'étendant depuis une première face de la couche et des seconds bossages s'étendant depuis une seconde face de la couche.

Dans un mode de réalisation, les couches conductrices supérieure et inférieure du substrat présentent des bossages uniquement sur une de leurs faces, et les couches conductrices intermédiaires, dans le cas où l'empilement est formé d'une nombre N de couches conductrices supérieur à deux, présentent des bossages sur leurs deux faces avec des épaisseurs variables en fonction de leur emplacement dans l'empilage.

Entre deux couches conductrices consécutives de l'empilement est disposée une couche isolante présentant des traversées par les bossages, ce qui permet lors de l'assemblage d'isoler électriquement le potentiel de chaque couche conductrice.

Cet isolant peut être lui-même intégrer une structure de circuit-imprimé. Cet isolant sera fabriqué avec et comme une structure de circuit imprimé avec les matériaux d'usage type (FR4, etc..) et des couches de cuivre de circuit imprimé d'épaisseur standard (17, 35µm). La couche isolante insérée entre les deux couches peut être constituée elle-même d'un emplilage de couches isolantes et de couches conductrices, d'épaisseur faible comme par exemple un circuit imprimé fin constitué de deux couches isolantes d'une épaisseur par exemple de 100 µm chacune entre lesquelles est insérée une couche conductrice gravée de 35 µm le tout réalisé comme un circuit imprimé unitaire indépendant.

La face supérieure de la couche conductrice supérieure du substrat peut former la première face du substrat et intégrer une structure classique de circuit imprimé permettant ainsi d'accueillir des composants destinés au contrôle des composants de puissance assemblés sur les différents bossages.

La face supérieure de la couche conductrice supérieure du substrat peut également permettre d'implanter des fonctions électroniques comme un capteur de mesure de courant en utilisant des procédés classique de métallisation entre les différentes couches conductrices utilisées pour la réalisation de l'assemblage au niveau des différents isolants utilisés pour l'assemblage des couches.

Selon un premier aspect du circuit électrique de puissance, ledit au moins un bossage d'une couche conductrice peut être réalisé en une seule pièce avec la couche conductrice depuis laquelle il s'étend.

Selon un second aspect du circuit électrique de puissance, ledit au moins un bossage d'une couche conductrice peut être reporté et fixé sur la couche conductrice depuis laquelle il s'étend.

Dans une variante, ledit au moins un bossage d'une couche conductrice peut être une pièce électriquement conductrice insérée en force dans une ouverture de la couche conductrice dudit bossage formant ainsi, dans la direction perpendiculaire au plan dans lequel s'étend la première face, un premier bossage s'étendant depuis la première face et un second bossage s'étendant depuis la seconde face du substrat.

Dans un deuxième objet de l'invention, il est proposé un boîtier de commande comprenant un système de filtrage d'une tension d'alimentation, un convertisseur de puissance électrique et un système de refroidissement des calories dissipées par les composants électronique du boîtier.

Selon une caractéristique générale du second objet, le convertisseur de puissance électrique comprend un circuit de puissance tel que défini ci-dessus, la seconde face du substrat du circuit étant en contact thermique avec ledit système de refroidissement.

Dans un troisième objet de l'invention, il est proposé un procédé fabrication d'un circuit électrique de puissance pour convertisseur de puissance électrique, le circuit comprenant un substrat présentant une première face sur lequel sont montés des composants électroniques de puissance et une seconde face opposée à la première face et destinée à coopérer avec un système de refroidissement.

Selon une caractéristique générale du troisième objet, le procédé comprend :
- une étape de réalisation d'au moins deux couches conductrices en matériau électriquement et thermiquement conducteur,
- une étape de réalisation d'au moins une couche isolante en matériau électriquement isolant,
- une étape de formation d'un empilement d'au moins deux couches conductrices et d'au moins une couche isolante, deux couches conductrices successives dans l'empilement étant séparées par une couche isolante, et lesdites couches conductrices et isolante(s) s'étendant dans des plans parallèles au plan dans lequel s'étend la première face du substrat et étant mécaniquement associées ensemble, et
- une étape de solidarisation mécanique pour assembler mécaniquement ensemble lesdites couches conductrices et isolante(s),
chaque couche conductrice présentant deux faces opposées parallèles au plan dans lequel s'étend la première face du substrat et comportant, sur au moins une de ses deux faces, au moins un bossage s'étendant dans une direction perpendiculaire au plan dans lequel s'étend la première face du substrat, ledit au moins un bossage traversant au moins une autre couche conductrice et débouchant sur la première ou la seconde face du substrat.

Selon un premier aspect du procédé de fabrication, l'étape de réalisation d'au moins deux couches conductrices peut comprendre, pour chaque couche conductrice, un usinage mécanique ou chimique d'une plaque de matériau électriquement et thermiquement conducteur dont l'épaisseur avant usinage est au moins égale à la somme de l'épaisseur de la couche après usinage avec la dimension du bossage le plus grand s'étendant depuis une première face de ladite couche conductrice et, si la couche conductrice comprend des bossages sur deux faces opposées, la dimension du bossage le plus grand s'étendant depuis une seconde face de ladite couche conductrice opposée à ladite première couche.

Les bossages peuvent ainsi être réalisés en usinant mécaniquement ou chimiquement une plaque de cuivre d'épaisseur plus importante afin d'obtenir les reliefs nécessaires à l'imbrication des différentes couches.

Selon un deuxième aspect du procédé de fabrication, l'étape de réalisation d'au moins deux couches conductrices peut comprendre une formation dudit au moins un bossage par estampage ou usinage de pièces en matériau électriquement et thermiquement conducteur puis un report dudit au moins un bossage ainsi formé sur une plaque de matériau électriquement et thermiquement conducteur pour obtenir une couche de conductrice dotée de bossages.

Les bossages peuvent ainsi être réalisés en utilisant des pièces de la forme et de la hauteur correspondant aux différents bossages à créer sur les plaques de cuivre. Ces pièces peuvent être obtenues soit par estampage, soit par usinage. Ces pièces sont alors reportées sur les plaques de cuivre et sont soit collées au moyen d'une colle permettant un transfert aussi bien thermique qu'électrique, soit brasées au moyen d'un apport d'alliage, soit frittées au moyen de l'apport de nanoparticules d'argent.

Un des avantages de cette méthode est de pouvoir utiliser des matériaux permettant d'obtenir des coefficients de dilatation proches de ceux des matériaux constitutifs de la puce nue du composant de puissance reportée sur le bossage. Par exemple, des matériaux tels que des alliages de cuivre ou d'aluminium revêtu de tout matériau permettant le report d'un composant électronique peuvent être utilisés.

Dans le deuxième aspect du procédé de fabrication, le report dudit au moins un bossage peut comporter un collage dudit bossage à l'aide d'une colle électriquement et thermiquement conductrice, ou bien un brasage dudit bossage au moyen d'un apport d'alliage, ou bien un frittage dudit bossage au moyen d'un apport de nanoparticules d'argent.

Selon un troisième aspect du procédé de fabrication, l'étape de réalisation d'au moins deux couches conductrices peut comprendre une réalisation de chaque couche conductrice dotée de bossage en une seule pièce par fabrication additive.

Selon un quatrième aspect du procédé de fabrication, l'étape de solidarisation mécanique peut comprendre un collage desdites couches conductrices et isolante(s) ou une stratification de pré-imprégné desdites couches conductrices et isolante(s).

Le pré imprégné est une matière de base de fabrication des circuits imprimés. Le pré-imprégné est un matériau à base de fibre de verre imprégné par de la résine époxy ou autre dans un état non polymérisé et utilisé pour la réalisation par empilage de circuit imprimés.

Dans le cas où l'on désire réduire les distances d'isolement, dans le plan dans lequel s'étend les couches conductrices et isolante(s), entre les différents potentiels électriques, une structuration en 3D de l'isolant peut être utilisée. Cette structure 3D peut être réalisée par usinage ou par assemblage par collage ou en fabrication additive.

### Brève description des dessins.

L'invention sera mieux comprise à la lecture faite ci-après, à titre indicatif mais non limitatif, en référence aux dessins annexés sur lesquels :
- la figure 1 présente une représentation schématique d'un boîtier de commande comprenant un convertisseur de puissance électrique doté d'un circuit électrique de puissance selon un mode de réalisation de l'invention ; et
- la figure 2 présente un organigramme d'un procédé de fabrication d'un circuit électrique de la figure 1 selon un mode de mise en œuvre de l'invention.

### Description détaillée de modes de réalisation

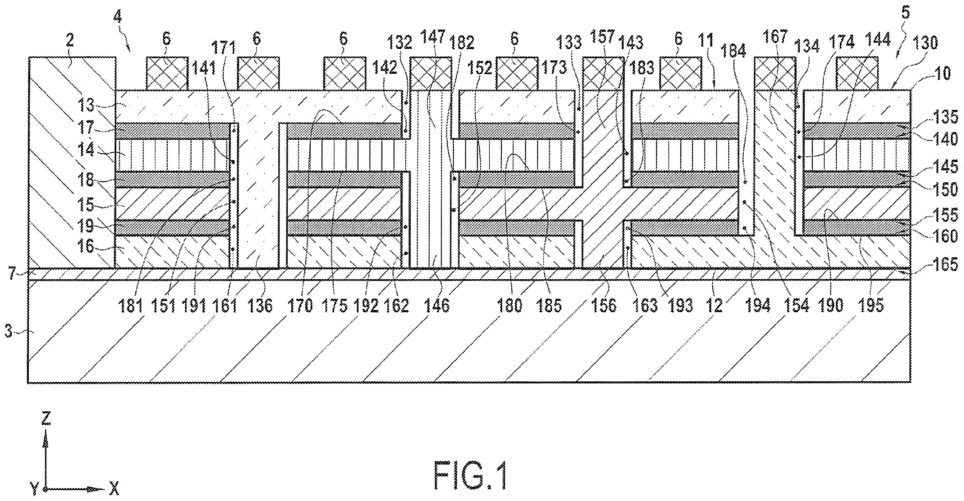

Sur la figure 1 est illustré une représentation schématique d'un boîtier de commande 1 comprenant un convertisseur de puissance électrique 4 doté d'un circuit électrique de puissance 5 selon un mode de réalisation de l'invention.

Le boîtier de commande 1 comprend un système de filtrage d'une tension d'alimentation 2, un système de refroidissement 3 des calories dissipées par les composants électronique du boîtier 1 et un convertisseur de puissance électrique 4.

Le convertisseur de puissance électrique 4 comprend circuit électrique de puissance 5 comportant un substrat 10 et des composants électroniques 6.

Le substrat 10 comprend une première face 11 sur laquelle sont montés les composants électroniques 6 et une seconde face 12 opposée à la première face 11. La première et la seconde face 11 et 12 s'étendent chacun dans un plan parallèle à un plan comprenant une première direction X et une deuxième direction Y. La seconde face 12 du substrat est isolée et assemblée au système de refroidissement 3 par collage à l'aide d'une colle thermiquement conductrice 7 par exemple. La seconde face 12 du substrat pourrait également être assemblée au système de refroidissement 3 par assemblage mécanique. Le système de refroidissement 3 peut être formé par un dissipateur thermique.

Dans le mode de réalisation illustré sur la figure 1, le substrat 10 comprend quatre couches conductrices 13 à 16 en matériau électriquement et thermiquement conducteur et trois couches isolantes 17 à 19 en matériau électriquement isolant. Les couches conductrices 13 à 16 et les couches isolantes 17 à 19 sont empilées en alternance dans une troisième direction Z orthogonale aux première et deuxième directions X et Y, de manière à obtenir un empilement successif de couches conductrices séparées par des couches isolantes.

En d'autres termes, l'empilement de couches comprend une couche conductrice 16 sur laquelle sont empilées ensuite au moins une superposition formée d'une couche isolante 19 et d'une couche conductrice 15, deux couches conductrices successives étant séparées par une couche isolante. Dans le mode de réalisation illustré sur la figure 1, l'empilement formant le substrat 10 est formé d'une couche conductrice 16 sur laquelle sont empilés successivement trois superpositions formées d'une couche isolante, respectivement 19, 18 et 17, et d'une couche conductrice, respectivement, 15, 14 et 13.

Chaque couche conductrice 13, 14, 15 et 16 comprend une première face, respectivement référencée 130, 140, 150 et 160, et une seconde face, respectivement référencée 135, 145, 155 et 165, s'étendant chacune dans un plan parallèle au plan XY comprenant les première et deuxième directions X et Y.

La première face 130 de la première couche conductrice 13 forme la première face 11 du substrat 10 du circuit électrique de puissance 4 sur laquelle sont montés les composants électroniques 6. La seconde face 135 de la première couche conductrice 13 est disposée en regard de la première face 140 de la deuxième couche conductrice 14, la seconde face 135 de la première couche conductrice 13 étant séparée de la première face 140 de la deuxième couche conductrice 14 par la première couche isolante 17. La seconde face 145 de la deuxième couche conductrice 14 est en regard de la première face 150 de la troisième couche conductrice 15, la seconde face 145 de la deuxième couche conductrice 14 étant séparée de la première face 150 de la troisième couche conductrice 15 par la deuxième couche isolante 18. La seconde face 155 de la troisième couche conductrice 15 est en regard de la première face 160 de la quatrième couche conductrice 16, la seconde face 155 de la troisième couche conductrice 15 étant séparée de la première face 160 de la quatrième couche conductrice 16 par la troisième couche isolante 19. La seconde face 165 de la quatrième couche conductrice 16 forme la seconde face 12 du substrat 10.

Dans le mode de réalisation illustré sur la figure 1, chaque couche conductrice 13 à 16 comprend trois passages notés respectivement 132, 133, 134, 141, 143, 144, 151, 152, 154, et 161, 162 et 163 et chaque couche isolante 17 à 19 comprend quatre passages notés respectivement 171 à 174, 81 à 184 et 191 à 194.

La première couche conductrice 13 comprend en outre un bossage 136 s'étendant dans la troisième direction Z depuis la seconde face 135 de la première couche conductrice 13 vers le dissipateur thermique du système de refroidissement 3, c'est-à-dire vers la seconde face 12 du substrat 10. Le bossage 136 de la première couche conductrice 13 traverse le premier passage 171 de la première couche isolante 17, le premier passage 141 de la deuxième couche conductrice 14, le premier passage 181 de la deuxième couche isolante 18, le premier passage 151 de la troisième couche conductrice 15, le premier passage 191 de la troisième couche isolante 19, et le premier passage 161 de la quatrième couche conductrice 16. Le bossage 136 de la première couche conductrice 13 débouche ainsi sur la seconde face 12 du substrat 10 en traversant les autres couches 14 à 16 et 17 à 19 du substrat pour être directement en contact avec le système de refroidissement 3.

La deuxième couche conductrice 14 comprend en outre un premier bossage 146 s'étendant dans la troisième direction Z depuis la seconde face 145 de la deuxième couche conductrice 14 vers le dissipateur thermique du système de refroidissement 3, c'est-à-dire vers la seconde face 12 du substrat 10. Le premier bossage 146 de la deuxième couche conductrice 14 traverse le deuxième passage 182 de la deuxième couche isolante 18, le deuxième passage 152 de la troisième couche conductrice 15, le deuxième passage 192 de la troisième couche isolante 19, et le deuxième passage 162 de la quatrième couche conductrice 16. Le premier bossage 146 de la deuxième couche conductrice 14 débouche ainsi sur la seconde face 12 du substrat 10 en traversant les autres couches 15, 16, 18 et 19 du substrat 10 pour être directement en contact avec le système de refroidissement 3.

La deuxième couche conductrice 14 comprend également un second bossage 147 s'étendant dans la troisième direction Z depuis la première face 140 de la deuxième couche conductrice 14 vers les composants électroniques 6, c'est-à-dire vers la première face 11 du substrat 10. Le seconde bossage 147 de la deuxième couche conductrice 14 traverse le deuxième passage 172 de la première couche isolante 17 et le premier passage 132 de la première couche conductrice 13. Le second bossage 147 de la deuxième couche conductrice 14 débouche ainsi sur la première face 11 du substrat 10 en traversant la première couche isolante 16 et la première couche conductrice 13 du substrat 10 pour pouvoir être raccordée électriquement à un composant électronique 6.

La troisième couche conductrice 15 comprend un premier bossage 156 s'étendant dans la troisième direction Z depuis la seconde face 155 de la troisième couche conductrice 15 vers le dissipateur thermique du système de refroidissement 3, c'est-à-dire vers la seconde face 12 du substrat 10. Le premier bossage 156 de la troisième couche conductrice 15 traverse le troisième passage 193 de la troisième couche isolante 19 et le troisième passage 163 de la quatrième couche conductrice 16. Le premier bossage 156 de la troisième couche conductrice 15 débouche ainsi sur la seconde face 12 du substrat 10 en traversant la troisième couche isolante 19 et la quatrième couche conductrice 16 du substrat 10 pour être directement en contact avec le système de refroidissement 3.

La troisième couche conductrice 15 comprend également un second bossage 157 s'étendant dans la troisième direction Z depuis la première face 150 de la troisième couche conductrice 15 vers les composants électroniques 6, c'est-à-dire vers la première face 11 du substrat 10. Le seconde bossage 157 de la troisième couche conductrice 15 traverse le troisième passage 183 de la seconde couche isolante 18, le deuxième passage 143 de la deuxième couche conductrice 14, le troisième passage 173 de la première couche isolante 17 et le deuxième passage 133 de la première couche conductrice 13. Le second bossage 157 de la troisième couche conductrice 15 débouche ainsi sur la première face 11 du substrat 10 en traversant les autres couches 13, 14, 17 et 18 du substrat 10 pour pouvoir être raccordée électriquement à un composant électronique 6.

La quatrième couche conductrice 16 comprend un bossage 167 s'étendant dans la troisième direction Z depuis la première face 160 de la quatrième couche conductrice 16 vers les composants électroniques 6, c'est-à-dire vers la première face 11 du substrat 10. Le bossage 167 de la quatrième couche conductrice 16 traverse le quatrième passage 194 de la troisième couche isolante 19, le troisième passage 154 de la troisième couche conductrice 15, le quatrième passage 184 de la seconde couche isolante 18, le troisième passage 144 de la deuxième couche conductrice 14, le quatrième passage 174 de la première couche isolante 17 et le troisième passage 134 de la première couche conductrice 13. Le bossage 167 de la quatrième couche conductrice 16 débouche ainsi sur la première face 11 du substrat 10 en traversant les autres couches 13, 14, 15, 17, 18 et 19 du substrat 10 pour pouvoir être raccordée électriquement à un composant électronique 6.

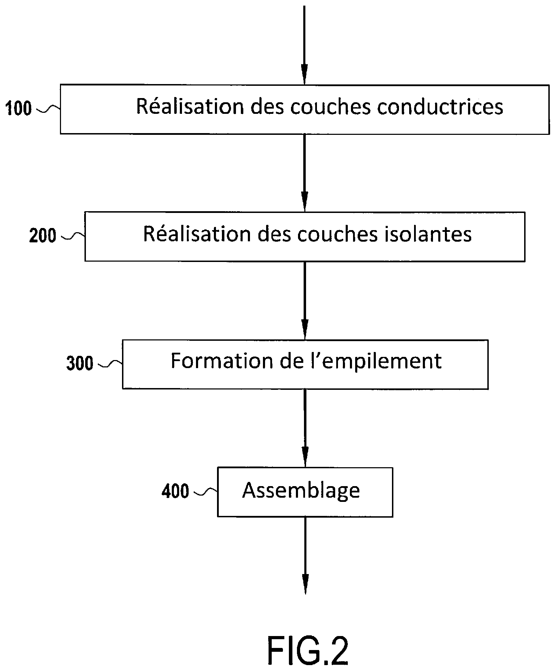

Sur la figure 2 est illustré un organigramme d'un procédé de fabrication d'un substrat 10 d'un circuit électrique de puissance 5 du convertisseur 4 de la figure 1 selon un mode de mise en œuvre de l'invention.

Dans une première étape 100, on réalise quatre couches conductrices 13 à 16 à partir de quatre plaques de cuivre dont l'épaisseur initiale de chacune correspond à l'épaisseur du substrat 10.

Dans ce mode de mise en œuvre, chaque couche conductrice 13 à 16 est réalisée en usinant une plaque de cuivre par traitement chimique en formant des bossages sur une ou deux des faces de la couche conductrice.

Dans une deuxième étape 200, on réalise trois couches isolantes 17 à 19 en matériau électriquement isolant à partir de trois plaques en matière isolante utilisée dans la fabrication des circuits imprimés, comme par exemple les pré-imprégnés, le FR4 ou le polyimide, dans lesquelles sont percés des orifices pour permettre le passage des différents bossages des plaques conductrices.

Dans une troisième étape 300, on forme un empilement à partir des couches conductrices et isolantes, en superposant alternativement une couche conductrice avec une couche isolante l'empilement présentant une première face 11 et une face seconde face 12 formées chacune par une couche conductrice.

Dans une quatrième étape 400, on assemble mécaniquement p ensemble toutes les couches conductrices et isolantes de l'empilement. Cet assemblage est réalisé par collage ou par stratification de l'ensemble, c'est-à-dire une mise sous pression de l'ensemble sous température, l'objectif étant une polymérisation des matériaux du type pré-imprégné utilisé pour les couches isolants.

L'invention permet ainsi de fabriquer un circuit électrique de puissance d'un convertisseur de puissance électrique pour un boîtier de commande d'au moins une machine tournante dont l'encombrement est réduit tout en présentant un refroidissement et une performance de conversion optimaux, le circuit électrique pouvant être utilisé pour toute puissance électrique à convertir.

## Revendications

1. Circuit électrique de puissance (5) pour convertisseur de puissance électrique (4), le circuit (5) comprenant un substrat (10) présentant une première face (11) sur lequel sont montés des composants électroniques (6) de puissance et une seconde face (12) opposée à la première face (11) et destinée à coopérer avec un système de refroidissement (3),
**caractérisé en ce que** le substrat (10) comprend un empilement d'une pluralité de couches conductrices (13, 14, 15, 16) en matériau électriquement et thermiquement conducteur et d'au moins une couche isolante (17, 18, 19) en matériau électriquement isolant, deux couches conductrices successives (13, 14, 15, 16) dans l'empilement étant séparées par une couche isolante (17, 18, 19), et lesdites couches conductrices et isolante(s) (13, 14, 15, 16, 17, 18, 19) s'étendant dans des plans parallèles au plan (XY) dans lequel s'étend la première face (11) du substrat (10) et étant mécaniquement associées ensemble,
et **en ce que** chaque couche conductrice (13, 14, 15, 16) présente deux faces opposées (130 et 135, 140 et 145, 150 et 155, 160 et 165) parallèles au plan (XY) dans lequel s'étend la première face (11) du substrat (10) et comporte, sur au moins une de ses deux faces, au moins un bossage (136, 146, 147, 156, 157, 167) s'étendant dans une direction (Z) perpendiculaire au plan (XY) dans lequel s'étend la première face (11) du substrat (10), ledit au moins un bossage (136, 146, 147, 156, 157, 167) traversant au moins une autre couche conductrice et débouchant sur la première ou la seconde face (11, 12) du substrat (10).

2. Circuit (5) selon la revendication 1, dans lequel ledit au moins un bossage (136, 146, 147, 156, 157, 167) d'une couche conductrice (13, 14, 15, 16) est réalisé en une seule pièce avec la couche conductrice depuis laquelle il s'étend.

3. Circuit (5) selon la revendication 1, dans lequel ledit au moins un bossage (136, 146, 147, 156, 157, 167) d'une couche conductrice (13, 14, 15, 16) est reporté et fixé sur la couche conductrice depuis laquelle il s'étend.

4. Circuit (5) selon la revendication 1, dans lequel ledit au moins un bossage (136, 146, 147, 156, 157, 167) d'une couche conductrice (13, 14, 15, 16) est une pièce électriquement conductrice insérée en force dans une ouverture de ladite couche conductrice (13, 14, 15, 16) formant ainsi, dans la direction perpendiculaire (Z) au plan (XY) dans lequel s'étend la première face (11), un premier bossage s'étendant depuis la première face (11) et un second bossage s'étendant depuis la seconde face (12) du substrat (10).

5. Boîtier de commande (1) comprenant un système de filtrage (2) d'une tension d'alimentation, un convertisseur de puissance électrique (4) et un système de refroidissement (3) des calories dissipées par les composants électronique (6) dudit boîtier (1), **caractérisé en ce que** le convertisseur de puissance électrique (4) comprend un circuit électrique de puissance (5) selon l'une des revendications 1 à 3, la seconde face (12) du substrat (10) dudit circuit (5) étant en contact thermique avec ledit système de refroidissement (3).

6. Procédé de fabrication d'un circuit électrique de puissance (5) pour convertisseur de puissance électrique (4) comprenant un substrat (10) présentant une première face (11) sur lequel sont montés des composants électroniques (6) de puissance et une seconde face (12) opposée à la première face (11) et destinée à coopérer avec un système de refroidissement (3),
**caractérisé en ce que** le procédé comprend :
- une étape (100) de réalisation d'au moins deux couches (13, 14, 15, 16) conductrices en matériau électriquement et thermiquement conducteur,
- une étape (200) de réalisation d'au moins une couche isolante (17, 18, 19) en matériau électriquement isolant,
- une étape (300) de formation d'un empilement d'au moins deux couches conductrices (13, 14, 15, 16) et d'au moins une couche isolante (17, 18, 19), deux couches conductrices successives dans l'empilement étant séparées par une couche isolante, et lesdites couches conductrices et isolante(s) s'étendant dans des plans parallèles au plan (XY) dans lequel s'étend la première face du substrat et étant mécaniquement associées ensemble, et
- une étape (400) de solidarisation mécanique pour assembler mécaniquement ensemble lesdites couches conductrices et isolante(s) (13, 14, 15, 16, 17, 18, 19),
chaque couche conductrice (13, 14, 15, 16) présentant deux faces opposées(130 et 135, 140 et 145, 150 et 155, 160 et 165) parallèles au plan (XY) dans lequel s'étend la première face (11) du substrat (10) et comportant, sur au moins une de ses deux faces, au moins un bossage (136, 146, 147, 156, 157, 167) s'étendant dans une direction (Z) perpendiculaire au plan (XY) dans lequel s'étend la première face (11) du substrat (10), ledit au moins un bossage (136, 146, 147, 156, 157, 167) traversant au moins une autre couche conductrice et débouchant sur la première ou la seconde face (11, 12) du substrat (10).

7. Procédé selon la revendication 6, dans lequel l'étape (100) de réalisation d'au moins deux couches conductrices comprend, pour chaque couche conductrice, un usinage mécanique ou chimique d'une plaque de matériau électriquement et thermiquement conducteur dont l'épaisseur avant usinage est au moins égale à la somme de l'épaisseur de la couche après usinage avec la dimension du bossage (136, 146, 147, 156, 157, 167) le plus grand s'étendant depuis une première face de ladite couche conductrice et, si la couche conductrice comprend des bossages sur deux faces opposées, la dimension du bossage le plus grand s'étendant depuis une seconde face de ladite couche conductrice opposée à ladite première couche.

8. Procédé selon la revendication 6, dans lequel l'étape (100) de réalisation d'au moins deux couches conductrices comprend une formation dudit au moins un bossage (136, 146, 147, 156, 157, 167) par estampage ou usinage de pièces en matériau électriquement et thermiquement conducteur puis un report dudit au moins un bossage (136, 146, 147, 156, 157, 167) ainsi formé sur une plaque de matériau électriquement et thermiquement conducteur pour obtenir une couche de conductrice dotée de bossages.

9. Procédé selon la revendication 8, dans lequel le report dudit au moins un bossage (136, 146, 147, 156, 157, 167) comporte un collage dudit bossage à l'aide d'une colle électriquement et thermiquement conductrice, ou bien un brasage dudit bossage au moyen d'un apport d'alliage, ou bien un frittage dudit bossage au moyen d'un apport de nanoparticules d'argent.

10. Procédé selon la revendication 6, dans lequel l'étape (100) de réalisation d'au moins deux couches conductrices comprend une réalisation de chaque couche conductrice (13, 14, 15, 16) dotée de bossage (136, 146, 147, 156, 157, 167) en une seule pièce par fabrication additive.

11. Procédé selon l'une des revendications 6 à 10, dans lequel l'étape (400) de solidarisation mécanique comprend un collage desdites couches conductrices et isolante(s) (13, 14, 15, 16, 17, 18, 19) ou une stratification de pré-imprégné desdites couches conductrices et isolante(s) (13, 14, 15, 16, 17, 18, 19).

## Patentansprüche

1. Elektrische Leistungsschaltung (5) für elektrischen Leistungswandler (4), wobei die Schaltung (5) ein Substrat (10) umfasst, das eine erste Fläche (11) aufweist, auf dem elektronische Leistungsbauteile (6) angebracht sind, und eine zweite Fläche (12) gegenüber der ersten Fläche (11) und die bestimmt ist, mit einem Kühlsystem (3) zusammenzuwirken,
**dadurch gekennzeichnet, dass** das Substrat (10) einen Stapel aus einer Vielzahl leitender Schichten (13, 14, 15, 16) aus elektrisch und thermisch leitendem Material und mindestens eine Isolierschicht (17, 18, 19) aus elektrisch isolierendem Material umfasst, wobei zwei im Stapel aufeinanderfolgende leitende Schichten (13, 14, 15, 16) durch eine Isolierschicht (17, 18, 19) getrennt sind, und sich die leitenden und isolierende(n) Schichten (13, 14, 15, 16, 17, 18, 19) in Ebenen erstrecken, die parallel zur Ebene (XY) sind, in welcher sich die erste Fläche (11) des Substrats (10) erstreckt, und mechanisch miteinander verbunden sind,
und dass jede leitende Schicht (13, 14, 15, 16) zwei gegenüberliegende Flächen (130 und 135, 140 und 145, 150 und 155, 160 und 165) aufweist, die parallel zur Ebene (XY) sind, in welcher sich die erste Fläche (11) des Substrats (10) erstreckt, und auf mindestens einer ihrer zwei Flächen mindestens eine Erhebung (136, 146, 147, 156, 157, 167) aufweist, die sich in einer Richtung (Z) erstreckt, die senkrecht zur Ebene (XY) ist, in welcher sich die erste Fläche (11) des Substrats (10) erstreckt, wobei die mindestens eine Erhebung (136, 146, 147, 156, 157, 167) mindestens eine andere leitende Schicht durchquert und auf der ersten oder der zweiten Fläche (11, 12) des Substrats (10) ausmündet.

2. Schaltung (5) nach Anspruch 1, wobei die mindestens eine Erhebung (136, 146, 147, 156, 157, 167) einer leitenden Schicht (13, 14, 15, 16) aus einem einzigen Teil mit der leitenden Schicht hergestellt ist, ab der sie sich erstreckt.

3. Schaltung (5) nach Anspruch 1, wobei die mindestens eine Erhebung (136, 146, 147, 156, 157, 167) einer leitenden Schicht (13, 14, 15, 16) versetzt und auf der leitenden Schicht befestigt ist, ab der sie sich erstreckt.

4. Schaltung (5) nach Anspruch 1, wobei die mindestens eine Erhebung (136, 146, 147, 156, 157, 167) einer leitenden Schicht (13, 14, 15, 16) ein elektrisch leitendes Teil ist, das in eine Öffnung der leitenden Schicht (13, 14, 15, 16) eingepresst ist und so in einer senkrechten Richtung (Z) zur Ebene (XY), in welcher sich die erste Fläche (11) erstreckt, eine erste Erhebung bildet, die sich ab der ersten Fläche (11) erstreckt, und eine zweite Erhebung, die sich ab der zweiten Fläche (12) des Substrats (10) erstreckt.

5. Steuerkasten (1), umfassend ein Filtersystem (2) einer Versorgungsspannung, einen elektrischen Leistungswandler (4) und ein Kühlsystem (3) der von den elektronischen Bauteilen (6) des Kastens (1) abgegebenen Kalorien, **dadurch gekennzeichnet, dass** der elektrische Leistungswandler (4) eine elektrische Leistungsschaltung (5) nach einem der Ansprüche 1 bis 3 umfasst, wobei die zweite Fläche (12) des Substrats (10) der Schaltung (5) in thermischem Kontakt mit dem Kühlsystem (3) ist.

6. Verfahren zur Herstellung einer elektrischen Leistungsschaltung (5) für einen elektrischen Leistungswandler (4), der ein Substrat (10) umfasst, das eine erste Fläche (11) aufweist, auf dem elektronische Leistungsbauteile (6) angebracht sind, und eine zweite Fläche (12) gegenüber der ersten Fläche (11) und die bestimmt ist, mit einem Kühlsystem (3) zusammenzuwirken,
**dadurch gekennzeichnet, dass** das Verfahren umfasst:
- einen Schritt (100) des Herstellens von mindestens zwei leitenden Schichten (13, 14, 15, 16) aus elektrisch und thermisch leitendem Material,
- einen Schritt (200) des Herstellens von mindestens einer Isolierschicht (17, 18, 19) aus elektrisch isolierendem Material,
- einen Schritt (300) des Bildens eines Stapels aus mindestens zwei leitenden Schichten (13, 14, 15, 16) und mindestens einer Isolierschicht (17, 18, 19), wobei zwei im Stapel aufeinanderfolgende leitende Schichten durch eine Isolierschicht getrennt sind, und sich die leitenden und isolierende(n) Schichten in Ebenen erstrecken, die parallel zur Ebene (XY) sind, in welcher sich die erste Fläche des Substrats erstreckt, und mechanisch miteinander verbunden sind, und
- einen Schritt (400) der mechanischen festen Verbindung, um die leitenden und isolierende(n) Schichte(n) (13, 14, 15, 16, 17, 18, 19) mechanisch miteinander zu verbinden,
wobei jede leitende Schicht (13, 14, 15, 16) zwei gegenüberliegende Flächen (130 und 135, 140 und 145, 150 und 155, 160 und 165) aufweist, die parallel zur Ebene (XY) sind, in welcher sich die erste Fläche (11) des Substrats (10) erstreckt, und auf mindestens einer ihrer zwei Flächen mindestens eine Erhebung (136, 146, 147, 156, 157, 167) aufweist, die sich in einer Richtung (Z) erstreckt, die senkrecht zur Ebene (XY) ist, in welcher sich die erste Fläche (11) des Substrats (10) erstreckt, wobei die mindestens eine Erhebung (136, 146, 147, 156, 157, 167) mindestens eine andere leitende Schicht durchquert und auf der ersten oder der zweiten Fläche (11, 12) des Substrats (10) ausmündet.

7. Verfahren nach Anspruch 6, wobei der Schritt (100) des Herstellens von mindestens zwei leitenden Schichten für jede leitende Schicht eine mechanische oder chemische Bearbeitung einer Platte aus elektrisch und thermisch leitendem Material umfasst, deren Dicke vor der Bearbeitung mindestens gleich der Summe der Dicke der Schicht nach der Bearbeitung mit der Abmessung der größten Erhebung (136, 146, 147, 156, 157, 167) entspricht, die sich ab einer ersten Fläche der leitenden Schicht erstreckt und, wenn die leitende Schicht Erhebungen auf zwei gegenüberliegenden Flächen umfasst, sich die Abmessung der größten Erhebung ab einer zweiten Fläche der leitenden Schicht gegenüber der ersten Schicht erstreckt.

8. Verfahren nach Anspruch 6, wobei der Schritt (100) des Herstellens von mindestens zwei leitenden Schichten ein Bilden der mindestens einen Erhebung (136, 146, 147, 156, 157, 167) durch Stanzen oder Bearbeiten von Teilen aus elektrisch und thermisch leitendem Material umfasst, dann ein Übertragen der mindestens einen derart gebildeten Erhebung (136, 146, 147, 156, 157, 167) auf eine Platte aus elektrisch und thermisch leitendem Material, um eine mit Erhebungen ausgestattete leitende Schicht zu erhalten.

9. Verfahren nach Anspruch 8, wobei die Übertragung der mindestens einen Erhebung (136, 146, 147, 156, 157, 167) ein Kleben der Erhebung mit Hilfe eines elektrisch und thermisch leitenden Klebers oder auch ein Löten der Erhebung mittels eines Anlagerns einer Legierung oder auch ein Sintern der Erhebung mittels eines Anlagerns von Silbernanopartikeln aufweist.

10. Verfahren nach Anspruch 6, wobei der Schritt (100) des Herstellens von mindestens zwei leitenden Schichten eine Herstellung jeder leitenden Schicht (13, 14, 15, 16), die mit einer Erhebung (136, 146, 147, 156, 157, 167) versehen ist, aus einem einzigen Teil durch additive Fertigung umfasst.

11. Verfahren nach einem der Ansprüche 6 bis 10, wobei der Schritt (400) des mechanischen festen Verbindens ein Kleben der leitenden und isolierenden Schichten (13, 14, 15, 16, 17, 18, 19) oder ein Prepreg-Laminieren der leitenden und isolierenden Schichten (13, 14, 15, 16, 17, 18, 19) umfasst.

## Claims

1. An electric power circuit (5) for an electric power converter (4), the circuit (5) comprising a substrate (10) having a first face (11) on which electronic power components (6) are mounted and a second face (12) opposite to the first face (11) and intended to cooperate with a cooling system (3),
**characterized in that** the substrate (10) comprises a stack of a plurality of conductive layers (13, 14, 15, 16) made of electrically and thermally conductive material and at least one insulating layer (17, 18, 19) made of electrically insulating material, two successive conductive layers (13, 14, 15, 16) in the stack being separated by an insulating layer (17, 18, 19), and said conductive and insulating layers (13, 14, 15, 16, 17, 18, 19) extending in planes parallel to the plane (XY) in which the first face (11) of the substrate (10) extends and being mechanically associated together,
and **in that** each conductive layer (13, 14, 15, 16) has two opposite faces (130 and 135, 140 and 145, 150 and 155, 160 and 165) parallel to the plane (XY) in which the first face (11) of the substrate (10) extends and includes, on at least one of its two faces, at least one boss (136, 146, 147, 156, 157, 167) extending in a direction (Z) perpendicular to the plane (XY) in which the first face (11) of the substrate (10) extends, said at least one boss (136, 146, 147, 156, 157, 167) passing through at least one other conductive layer and opening out onto the first or the second face (11, 12) of the substrate (10).

2. The circuit (5) according to claim 1, wherein said at least one boss (136, 146, 147, 156, 157, 167) of a conductive layer (13, 14, 15, 16) is made in one piece with the conductive layer from which it extends.

3. The circuit (5) according to claim 1, wherein said at least one boss (136, 146, 147, 156, 157, 167) of a conductive layer (13, 14, 15, 16) is transferred and fixed on the conductive layer from which it extends.

4. The circuit (5) according to claim 1, wherein said at least one boss (136, 146, 147, 156, 157, 167) of a conductive layer (13, 14, 15, 16) is an electrically conductive part forcibly inserted into an opening of said conductive layer (13, 14, 15, 16) thus forming, in the direction perpendicular (Z) to the plane (XY) in which the first face (11) extends, a first boss extending from the first face (11) and a second boss extending from the second face (12) of the substrate (10).

5. A control unit (1) comprising a system for filtering (2) a supply voltage, an electric power converter (4) and a system for cooling (3) the calories dissipated by the electronic components (6) of said unit (1), **characterized in that** the electric power converter (4) comprises an electric power circuit (5) according to any of claims 1 to 3, the second face (12) of the substrate (10) of said circuit (5) being in thermal contact with said cooling system (3).

6. A method for manufacturing an electric power circuit (5) for an electric power converter (4) comprising a substrate (10) having a first face (11) on which electronic power components (6) are mounted and a second face (12) opposite to the first face (11) and intended to cooperate with a cooling system (3),
**characterized in that** the method comprises:
- a step (100) of producing at least two conductive layers (13, 14, 15, 16) made of electrically and thermally conductive material,
- a step (200) of producing at least one insulating layer (17, 18, 19) made of electrically insulating material,
- a step (300) of forming a stack of at least two conductive layers (13, 14, 15, 16) and at least one insulating layer (17, 18, 19), two successive conductive layers in the stack being separated by an insulating layer, and said conductive and insulating layers extending in planes parallel to the plane (XY) in which the first face of the substrate extends and being mechanically associated together, and
- a mechanical securing step (400) to mechanically assemble together said conductive and insulating layers (13, 14, 15, 16, 17, 18, 19), each conductive layer (13, 14, 15, 16) having two opposite faces (130 and 135, 140 and 145, 150 and 155, 160 and 165) parallel to the plane (XY) in which the first face (11) of the substrate (10) extends and including, on at least one of its two faces, at least one boss (136, 146, 147, 156, 157, 167) extending in a direction (Z) perpendicular to the plane (XY) in which the first face (11) of the substrate (10) extends, said at least one boss (136, 146, 147, 156, 157, 167) passing through at least one other conductive layer and opening out onto the first or the second face (11, 12) of the substrate (10).

7. The method according to claim 6, wherein the step (100) of producing at least two conductive layers comprises, for each conductive layer, a mechanical or chemical machining of a plate of electrically and thermally conductive material whose thickness before machining is at least equal to the sum of the thickness of the layer after machining with the dimension of the largest boss (136, 146, 147, 156, 157, 167) extending from a first face of said conductive layer and, if the conductive layer comprises bosses on two opposite faces, with the dimension of the largest boss extending from a second face of said conductive layer opposite to said first layer.

8. The method according to claim 6, wherein the step (100) of producing at least two conductive layers comprises a formation of said at least one boss (136, 146, 147, 156, 157, 167) by stamping or machining of parts made of electrically and thermally conductive material then a transfer of said at least one boss (136, 146, 147, 156, 157, 167) thus formed on a plate of electrically and thermally conductive material to obtain a conductive layer provided with bosses.

9. The method according to claim 8, wherein the transfer of said at least one boss (136, 146, 147, 156, 157, 167) includes a bonding of said boss using an electrically and thermally conductive adhesive, or a soldering of said boss by means of an alloy delivery, or a sintering of said boss by means of a delivery of silver nanoparticles.

10. The method according to claim 6, wherein the step (100) of producing at least two conductive layers comprises a production of each conductive layer (13, 14, 15, 16) provided with bosses (136, 146, 147, 156, 157, 167) in one piece by additive manufacturing.

11. The method according to any of claims 6 to 10, wherein the mechanical securing step (400) comprises a bonding of said conductive and insulating layers (13, 14, 15, 16, 17, 18, 19) or a prepreg lamination of said conductive and insulating layers (13, 14, 15, 16, 17, 18, 19).
